# EUROPEAN PATENT SPECIFICATION

(11) **EP 2 989 930 B1**
(45) Date of publication and mention of the grant of the patent: **06.12.2017**
(21) Application number: 14182876.4
(22) Date of filing: 29.08.2014
(51) Int. Cl.: A47B 88/493, H05K 7/14

(54) **Slide rail assembly**
Schienenanordnung
Ensemble de rail de glissement

(43) Date of publication of application: 02.03.2016
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Weng, Cheng-Chieh, Kaohsiung City (TW); Wang, Chun-Chiang, Kaohsiung City (TW)
(74) Representative: Viering, Jentschura & Partner mbB Patent- und Rechtsanwälte

(56) References cited:
- US-B1- 6 997 529
- US-B2- 7 413 269

## Description

### Field of the Invention

The present invention relates to a slide rail assembly, and more particularly, to a slide rail assembly of which two rails may be synchronously moved and when one of the rails is moved to a position, the rail may be remained at the position while the other rail may be further moved forward.

### Background of the Invention

Generally speaking, a server chassis is mounted on a rack by means of a pair of slide rail assemblies in server systems. The slide rail assembly is usually in a form constituted by two or three sections of rails to carry the server chassis. The difference is that three-section rails have longer extension lengths to meet actual specific requirements.

Among the technologies of three-section rails, the engagement between rails or the synchronous movement between rails along an extending direction has been common developed technologies, which also means that such related technologies have already become specific operational and commercial requirements. For example, U.S. Pat. No. 7,413,269 B2 and 6,997,529 B1 disclosed the engagement between engaging blocks and engaging holes (or engaging grooves) to ensure the positioning between rails and the synchronous movement.

### Summary of the Invention

The present invention is a slide rail assembly of which two rails may be synchronously moved and when one of the rails is moved to a position, the rail may be remained at the position while the other rail may be further moved forward.

The present invention provides a slide rail assembly comprising a first rail, a second rail, an actuating member, and a third rail. The first rail comprises a guiding portion. The second rail is longitudinally and movably connected to the first rail. The actuating member is movably connected to the second rail and comprises a contact portion. The third rail is longitudinally and movably connected to the second rail and comprises a hook portion. When the third rail is pulled with respect to the first rail with the contact portion of the actuating member engaging with the hook portion of the third rail, the second rail is synchronously moved along with the third rail. When the second rail is moved to a predetermined position with respect to the first rail, the actuating member rotates by an angle by guiding means of the guiding portion of the first rail and thereby disengages the contact portion of the actuating member from the hook portion of the third rail.

The guiding portion of the first rail comprises a horizontal section and an inclining section extending from the horizontal section. When the second rail is moved to the predetermined position with respect to the first rail, the actuating member is guided from the horizontal section to the inclining section and thereby rotates by the angle to disengage the contact portion of the actuating member from the hook portion of the third rail. Preferably, the guiding portion further comprises a blocking wall adjacent to the inclining section to further block the contact portion of the actuating member after the actuating member is guided from the horizontal section to the inclining section.

The second rail comprises a protrusion portion and the slide rail assembly further comprises a fixing member connected to the second rail. The fixing member comprises a contact section corresponding to the protrusion portion of the second rail and the actuating member further comprises a tail portion located between the contact section of the fixing member and the protrusion portion of the second rail.

The slide rail assembly further comprises a swinging member pivotally connected to the first rail and comprising a leg portion, wherein the second rail comprises an indention portion for the leg portion to press against; and an assisting member comprising an elastic guiding portion contacting the swinging member. When the second rail moves to the predetermined position, the swinging member presses the leg portion against the indention portion of the second rail by an elastic force generated by the elastic guiding portion.

The second rail has a first end portion and a second end portion opposite to the first end portion. The fixing member and the actuating member are adjacent to the first end portion of the second rail. The slide rail assembly further comprises an engaging member adjacent to the second end portion of the second rail, wherein the engaging member comprises a positioning portion. The third rail further comprises an opening corresponding to the positioning portion of the engaging member so that the positioning portion of the engaging member engages with and positions at the opening of the third rail when the third rail moves with respect to the second rail to an extended position. The engaging member comprises a base plate and an elastic portion bending from the base plate, wherein the positioning portion is located at the elastic portion. The slide rail assembly further comprises at least one restricting member attached to the second rail; and a releasing member mounted to the second rail and comprising a moving portion and a disengaging portion, wherein one of the moving portion and the disengaging portion comprises at least one longitudinal groove interacting with the at least one restricting member, and wherein the disengaging portion interacts with a portion of the swinging member. When the releasing member is pulled with respect to the at least one restricting member after engagement of the leg portion of the swinging member with the indention portion of the second rail, the swinging member is moved by means of the disengaging portion of the releasing member to disengage the leg portion of the swinging member from the indention portion of the second rail.

Another aspect of the present invention provides a slide rail assembly comprising a first rail, a second rail, a swinging member, and an assisting member. The second rail is longitudinally and movably connected to the first rail and comprises an indention portion. The swinging member is pivotally connected to the first rail and comprises a leg portion corresponding to the indention portion of the second rail. The assisting member is adjacent to the swinging member and comprises an elastic guiding portion contacting the swinging member. When the second rail moves to a predetermined position with respect to the first rail, the swinging member pivots in response to an elastic force generated by the elastic guiding portion to engage the leg portion of the swinging member with the indention portion of the second rail so that the second rail is positioned with respect to the first rail.

Another aspect of the present invention provides a slide rail assembly comprising a first rail, a second rail, a fixing member, an actuating member, a third rail, and a swinging member. The first rail comprises an upper wall, a lower wall, and a longitudinally extending body extending between the upper wall and the lower wall of the first rail, wherein the longitudinally extending body comprises a guiding portion comprising a horizontal section, an inclining section extending from the horizontal section, and a blocking wall adjacent to the inclining section. The second rail is longitudinally and movably connected to the first rail and comprises an upper wall, a lower wall, a longitudinally extending body extending between the upper wall and the lower wall of the second rail, and a protrusion portion located at the longitudinally extending body of the second rail, wherein one of the upper wall and the lower wall comprises an indention portion. The fixing member is connected to the second rail and comprises a contact section corresponding to the protrusion portion of the second rail. The actuating member is movably connected to the second rail and comprises a contact portion corresponding to the guiding portion of the first rail and a tail portion located between the contact section of the fixing member and the protrusion portion of the second rail. The third rail is longitudinally and movably connected to the second rail and comprises a hook portion corresponding to the contact portion of the actuating member. When the third rail is moved along an extending direction with the contact portion of the actuating member correspondingly engaging with the hook portion of the third rail, the second rail is synchronously moved along with the third rail. When the second rail is moved to a position corresponding to the guiding portion of the first rail, the contact portion of the actuating member is successively guided by the horizontal section and the inclining section of the guiding portion of the first rail. When the contact portion of the actuating member is guided by the inclining section, the actuating member rotates by means of the tail portion pressing against the contact section of the fixing member so that the contact portion of the actuating member disengages from the hook portion of the third rail and is then guided to and blocked by the blocking wall of the guiding portion. The swinging member is movably connected to the longitudinally extending body of the first rail and comprises a leg portion corresponding to the indention portion of the second rail, wherein when the second rail is synchronously moved along with the third rail to a predetermined position along the extending direction, the leg portion of the swinging member enters the indention portion of the second rail.

The second rail has a first end portion and a second end portion opposite to the first end portion. The fixing member and the actuating member are adjacent to the first end portion of the second rail. The slide rail assembly further comprises an engaging member adjacent to the second end portion of the second rail, wherein the engaging member comprises a positioning portion and the third rail further comprises an opening corresponding to the positioning portion of the engaging member so that the positioning portion of the engaging member engages with and positions at the opening of the third rail when the third rail moves with respect to the second rail to a position. The engaging member comprises a base plate and an elastic portion bending from the base plate, and wherein the positioning portion is located at the elastic portion.

The slide rail assembly further comprises at least one restricting member attached to the second rail; and a releasing member mounted to the longitudinally extending body of the second rail and adjacent to the indention portion of the second rail. The releasing member comprises a moving portion and a disengaging portion, wherein one of the moving portion and the disengaging portion comprises at least one longitudinal groove corresponding to the at least one restricting member, and wherein the disengaging portion corresponds to a portion of the swinging member. When the moving portion is operated after engagement of the leg portion of the swinging member with the indention portion of the second rail, the disengaging portion is driven to move the portion of the swinging member so that the leg portion of the swinging member is disengaged from the indention portion of the second rail again.

The third rail further comprises a guiding slant adjacent to the hook portion. When the third rail is retracted along a retracting direction, the contact portion of the actuating member is pressed back to engage with the hook portion of the third rail by the guiding slant of the third rail. The indention portion of the second rail comprises a slant. When the third rail is retracted along the retracting direction, the slant presses against the leg portion of the swinging member so that the leg portion deviates and leaves the indention portion of the second rail.

The slide rail assembly further comprises an operating member connected to the third rail to be operated to move the third rail along the extending direction. The longitudinally extending body of the first rail comprises a fixing portion. The operating member comprises a base plate portion connected to the third rail, an elastic plate bending from the base plate portion for providing an elastic force, and a handle portion connected to the elastic plate. The elastic plate comprises an engaging portion corresponding to the fixing portion of the longitudinally extending body of the first rail. When the third rail is retracted to a retracted position with respect to the first rail, the engaging portion of the elastic plate engages with the fixing portion by the elastic force provided by the elastic plate.

A feature of the invention is that when the third rail is moved along the extending direction, the second rail synchronously moves along with the third rail in the extending direction, and the second rail may temporarily remain at a position without moving along with the third rail when the position is arrived at, while the third rail may continue to move along the extending direction.

### Brief Description of the Drawings

FIG. 1 shows a perspective view of a slide rail assembly in accordance with the present invention;
FIG. 2 is a schematic view of the second rail and the third rail in FIG. 1, wherein the second rail and the third rail are assemble to each other, and wherein the third rail is pulled from the second rail by a distance;
FIG. 3 is a schematic exploded view of the first rail and the assembled second rail and third rail of the slide rail assembly in accordance with the present invention;
FIG. 4 is a schematic exploded view of the second rail and the third rail of the slide rail assembly in accordance with the present invention;
FIG. 5 is a detailed schematic view of a portion of the second rail of the slide rail assembly in FIG. 4, showing the configuration between a fixing member, a protrusion portion, and an actuating member;
FIG. 6 is a detailed schematic view of another portion of the second rail of the slide rail assembly in FIG. 4, showing a releasing member mounted to the second rail and adjacent to an indention portion of the second rail;
FIG. 7 is a detailed schematic view of still another portion of the second rail of the slide rail assembly in FIG. 4, showing an engaging member mounted adjacent to a second end portion of the second rail;
FIG. 8 is a detailed schematic view of a portion of the third rail of the slide rail assembly in FIG. 4, showing a hook portion and a guiding slant;
FIG. 9A schematically shows that the third rail of the slide rail assembly in accordance with the present invention engages with a contact portion of the actuating member by means of the hook portion;
FIG. 9B schematically shows that the second rail of the slide rail assembly in accordance with the present invention is synchronously moved along with the third rail by means of the contact portion of the actuating member engaging with the hook portion;
FIG. 9C schematically shows that the second rail of the slide rail assembly in accordance with the present invention is moved to a position and the contact portion of the actuating member is guided by a guiding portion of the first rail to disengage from the hook portion of the third rail;
FIG. 9D schematically shows that the second rail of the slide rail assembly in accordance the present invention is moved to a predetermined position and the contact portion of the actuating member is blocked by a blocking wall of the guiding portion of the first rail;
FIG. 10 schematically shows that the third rail of the slide rail assembly in accordance with the present invention is moved along an extending direction;
FIG. 11 schematically shows that the third rail of the slide rail assembly in accordance with the present invention is further moved along the extending direction so that an opening of the third rail corresponds to the engaging member;
FIG. 12 is a cross-section view taken along the line 12-12 of FIG. 10;
FIG. 13 is a cross-section view taken along the line 13-13 of FIG. 11;
FIG. 14 schematically shows that the third rail of the slide rail assembly in accordance with the present invention is at an extended position;
FIG. 15 schematically shows that the third rail of the slide rail assembly in accordance with the present invention is dismounted;
FIG. 16 is a cross-section view taken along the line 16-16 of FIG. 14, showing that a force is applied to an elastic portion of the engaging member;
FIG. 17A schematically shows that the second rail of the slide rail assembly in accordance with the present invention is extended from the firs rail;
FIG. 17B schematically shows that the releasing member of the slide rail assembly in accordance with the present invention is moved to disengage a leg portion of a swinging member from the indention portion of the second rail;
FIG. 17C schematically shows that the second rail of the slide rail assembly in accordance with an embodiment of the present invention is dismounted from the first rail;
FIG. 17D schematically shows that the second rail of the slide rail assembly in accordance with the present invention is dismounted from the first rail and a flexible member then moves the releasing member to return to the initial state;
FIG. 18A schematically shows that the third rail of the slide rail assembly in accordance with the present invention is moved along a retracting direction and the guiding slant of the third rail lifts the contact portion of the actuating member;
FIG. 18B schematically shows that the guiding slant of the third rail of the slide rail assembly in accordance with the present invention lifts and moves the contact portion of the actuating member away from the blocking wall of the guiding portion of the first rail; and
FIG. 18C schematically shows that the third rail of the slide rail assembly in accordance with the present invention is further moved along the retracting direction and the leg portion of the swinging member is thereby driven to leave the indention portion of the second rail by the slant.

### Detailed Description of the Invention

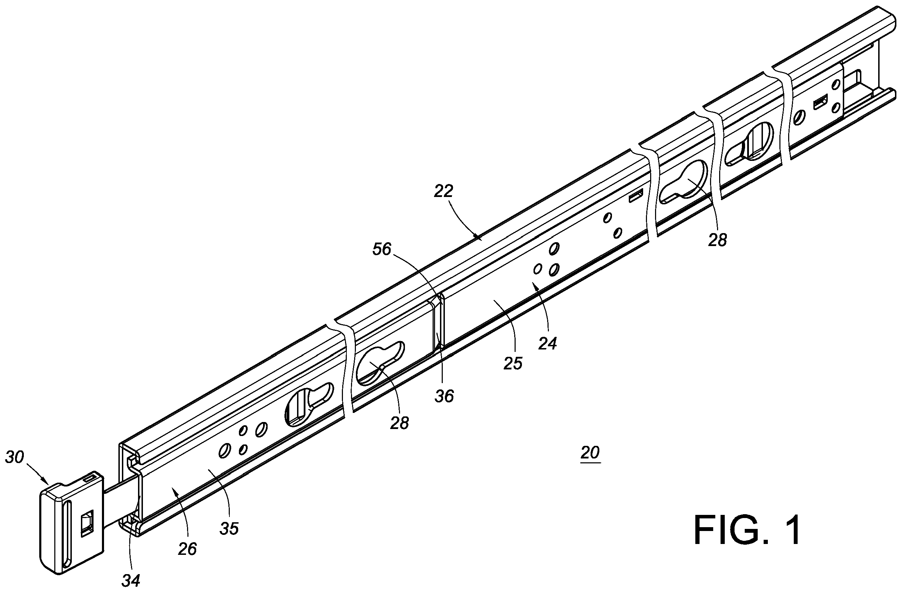

FIG. 1 shows a slide rail assembly 20 comprising a first rail 22, a second rail 24, and a third rail 26 at a retracted state according to an embodiment of the present invention. The second rail 24 and the third rail 26 may be longitudinally moved with respect to the first rail 22. Preferably, the second rail 24 and the third rail 26 each comprises at least one mounting portion 28 for mounting a chassis (such as a server chassis). Preferably, an operating member 30 is connected to the third rail 26 and configured to be operated to move the third rail 26 along an extending direction.

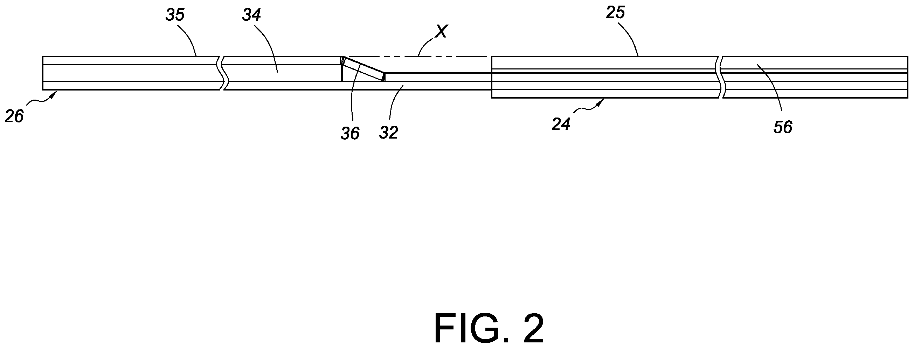

Referring to FIG. 1 and FIG. 2, FIG. 2 shows the third rail 26 comprising a first longitudinal portion 32, a second longitudinal portion 34, and a slant portion 36 connected between the first longitudinal portion 32 and the second longitudinal portion 34. The first longitudinal portion 32 of the third rail 26 is movably connected to the inside of the second rail 24, and the second longitudinal portion 34 of the third rail 26 extends from the slant portion 36 to be located outside the second rail 24.

As shown in FIG. 2, the second rail 24 comprises a longitudinally extending body 56 comprising a lateral side 25, and the second longitudinal portion 34 of the third rail 26 comprises a lateral side 35. The lateral side 35 of the second longitudinal portion 34 of the third rail 26 and the lateral side 25 of the longitudinally extending body 56 of the second rail 24 are substantially in a same reference plane X (the reference plane X is a fictitious plane, and the present invention is not limited thereto) by means of the slant portion 36. Each of the second rail 24 and the third rail 26 thereby may be mounted with a chassis, wherein the two chassis have substantially identical widths. In addition, the slant portion 36 of the third rail 26 may contact against the second rail 24 (as shown in FIG. 1).

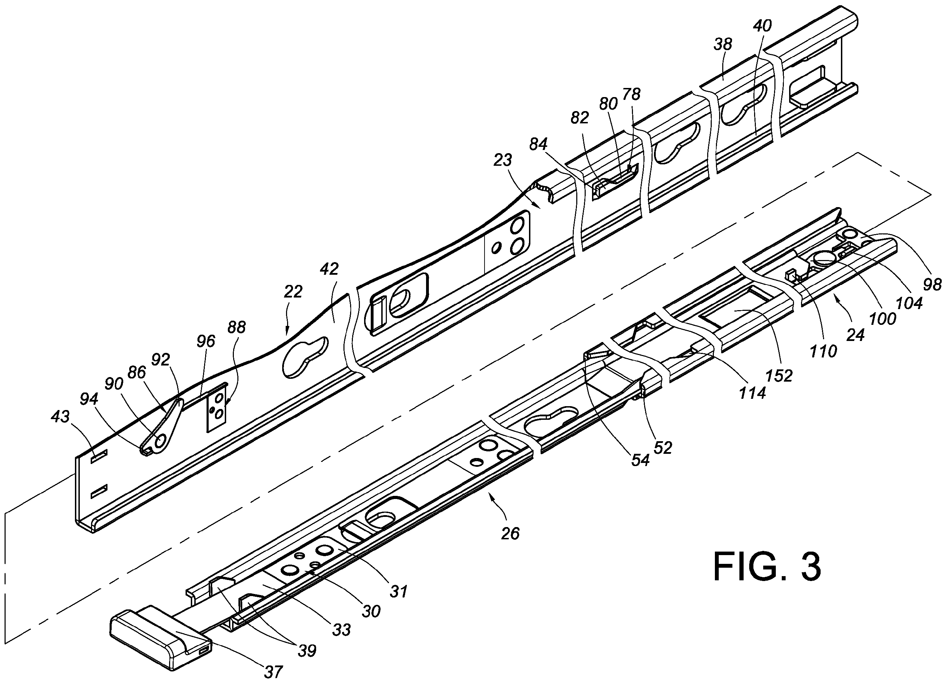

FIG. 3 shows the first rail 22 separated from the assembled second rail 24 and third rail 26.

The first rail 22 comprises an upper wall 38, a lower wall 40, and a longitudinally extending body 42 extending between the upper wall 38 and the lower wall 40, wherein the upper wall 38, the lower wall 40, and the longitudinally extending body 42 collectively define a first longitudinal channel 23. The longitudinally extending body 42 of the first rail 22 comprises a guiding portion 78, and more particularly, the guiding portion 78 is integrated with the longitudinally extending body 42 of the first rail 22, but the present invention is not limited thereto. The guiding portion 78 comprises a horizontal section 80, an inclining section 82 extending from the horizontal section 80, and a blocking wall 84 adjacent to the inclining section 82. Moreover, the longitudinally extending body 42 of the first rail 22 further comprises at least one fixing portion 43. In a preferred embodiment, the longitudinally extending body 42 of the first rail 22 comprises two fixing portions 43 which are holes (as in FIG. 3), but the present invention is not limited thereto.

The slide rail assembly 20 further comprises a swinging member 86 and an assisting member 88, wherein the swinging member 86 is movably connected to the longitudinally extending body 42 of the first rail 22. Preferably, the swinging member 86 is pivotally connected to the longitudinally extending body 42 of the first rail 22 by means of a first connection member 90. The swinging member 86 comprises a leg portion 92 and an extended side portion 94. The assisting member 88 is connected to the longitudinally extending body 42 of the first rail 22 and adjacent to the swinging member 86 and comprises a longitudinally extending elastic guiding portion 96, wherein the elastic guiding portion 96 of the assisting member 88 contacts the leg portion 92 of the swinging member 86.

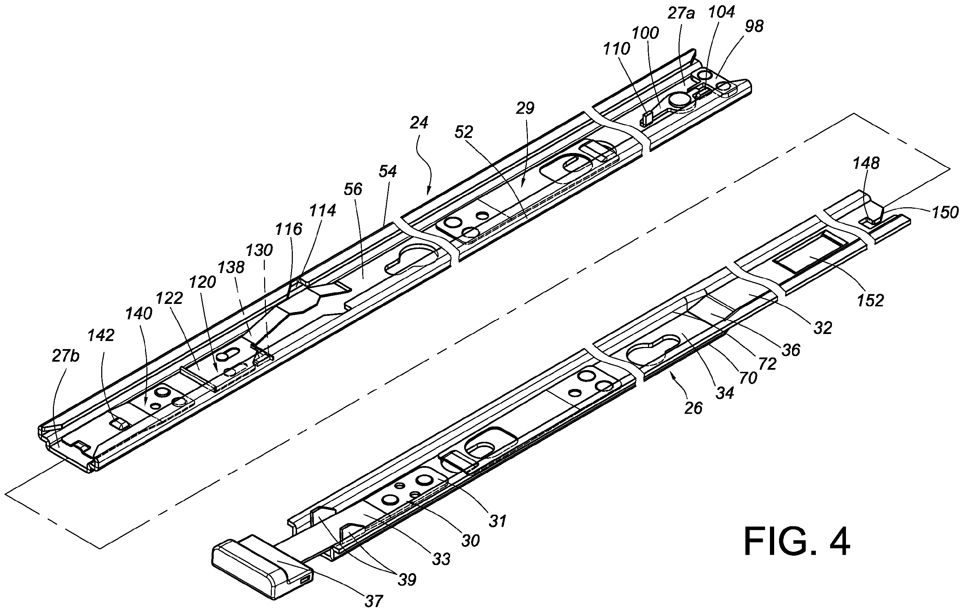

Referring to FIG. 3 and FIG. 4, FIG. 4 shows the second rail 24 separated from the third rail 26.

The second rail 24 is longitudinally and movably connected to the first rail 22, and more particularly, the second rail 24 is received in and movable along the first longitudinal channel 23 of the first rail 22. The second rail 24 comprises an upper wall 52, a lower wall 54, and a longitudinally extending body 56 extending between the upper wall 52 and the lower wall 54, wherein the upper wall 52, the lower wall 54, and the longitudinally extending body 56 collectively define a second longitudinal channel 29. The longitudinally extending body 56 of the second rail 24 comprises a first end portion 27a and a second end portion 27b opposite to the first end portion 27a. The second rail 24 further comprises a protrusion portion 104 located at the longitudinally extending body 56. The slide rail assembly 20 further comprises a fixing member 98 and an actuating member 100 which are connected to the second rail 24. In a preferred embodiment, the fixing member 98 and the actuating member 100 are adjacent to the first end portion 27a of the second rail 24.

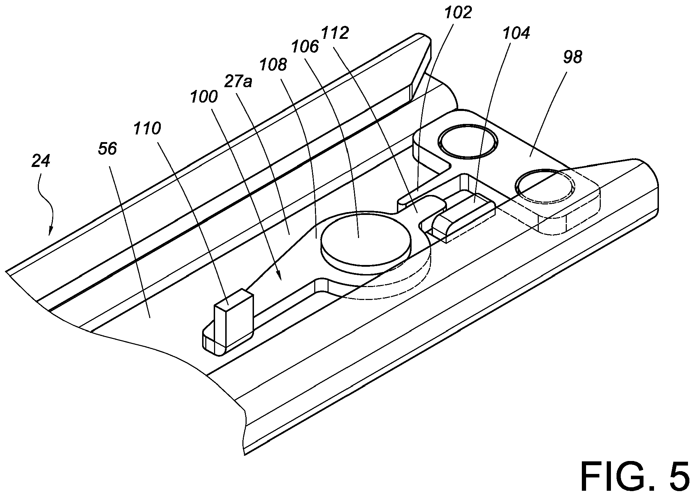

As shown in FIG. 5, the fixing member 98 comprises a contact section 102 corresponding in position to the protrusion portion 104 of the second rail 24. The actuating member 100 is movably connected to the longitudinally extending body 56 of the second rail 24. Preferably, the actuating member 100 is rotatably connected to the longitudinally extending body 56 of the second rail 24 by means of a second connection member 106. The actuating member 100 comprises a main body 108, a contact portion 110, and a tail portion 112.

The contact portion 110 may be, for example, a protrusion perpendicularly protruding from the main body 108 to contact and be guided by the guiding portion 78 of the longitudinally extending body 42 of the first rail 22, but the form of the contact portion 110 is not limited thereto. Preferably, the tail portion 112 of the actuating member 100 longitudinally extends from the main body 108, but the present invention is not limited thereto. The tail portion 112 of the actuating member 100 is located between the contact section 102 of the fixing member 98 and the protrusion portion 104 of the second rail 24. In addition, one of the upper wall 52 and the lower wall 54 of the second rail 24 comprises an indention portion 114, wherein the indention portion 114 comprises a slant 116.

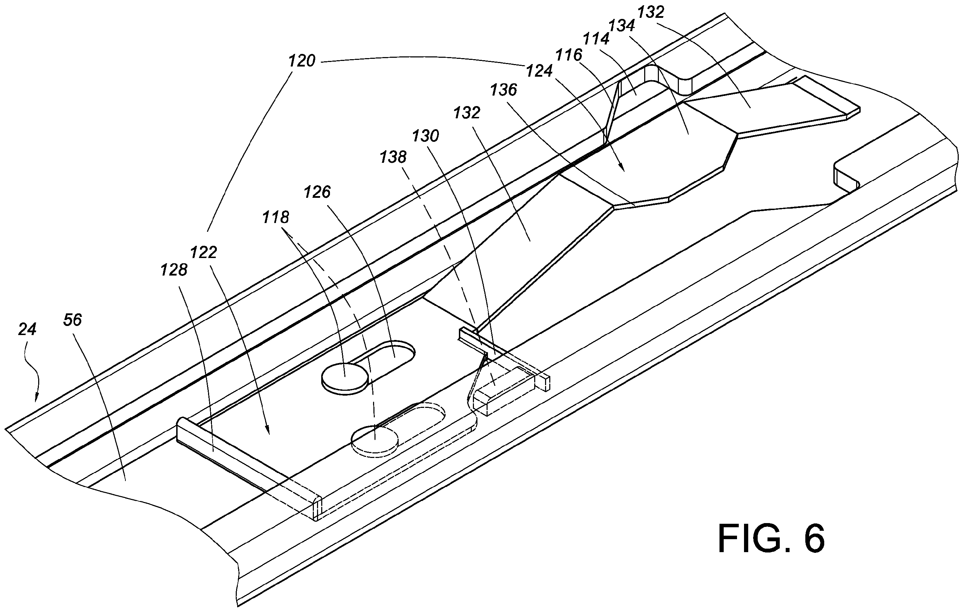

As shown in FIG. 4 and FIG. 6, the slide rail assembly 20 further comprises at least one restricting member 118 and a releasing member 120, wherein the restricting member 118 is attached to the second rail 24 and the releasing member 120 is mounted to the longitudinally extending body 56 of the second rail 24. The releasing member 120 is adjacent to the indention portion 114 of the second rail 24.

The releasing member 120 comprises a moving portion 122 and a disengaging portion 124 extending from the moving portion 122. One of the moving portion 122 and the disengaging portion 124 comprises at least one longitudinal groove 126 corresponding to the at least one restricting member 118, an operating portion 128 connected to one of the moving portion 122 and the disengaging portion 124, and a flexible member 130 connected to one of the moving portion 122 and the disengaging portion 124. In a preferred embodiment, the at least one longitudinal groove 126 is disposed on the moving portion 122, the operating portion 128 is connected to the moving portion 122, and the flexible member 130 is laterally connected to the moving portion 122, but the present invention is not limited thereto. Moreover, by means of the structural configuration of the restricting member 118 and the longitudinal groove 126, the releasing member 120 is longitudinally movable with respect to the restricting member 118 when the operating portion 128 is longitudinally operated. Preferably, the restricting member 118 is disposed within the longitudinal groove 126 so that the movement of the moving portion 122 can be stopped once either end of the longitudinal groove 126 contacts the restricting member 118 (as in FIG. 6).

The disengaging portion 124 comprises at least one slant plate 132 and a flat plate 134 connected to the slant plate 132. In a preferred embodiment, there are two slant plates 132 and the flat plate 134 is connected between the two slant plates 132, wherein one of the two slant plates 132 is connected to the moving portion 122 and bends from the moving portion 122 by an angle, but the present invention is not limited thereto. The flat plate 134 comprises a disengaging edge 136. The longitudinally extending body 56 of the second rail 24 further comprises a blocking member 138, wherein a portion of the flexible member 130 can be correspondingly pressed against the blocking member 138. In more detail, the flexible member 130 is an elongated plate extending from the moving portion 122 of the releasing member 120.

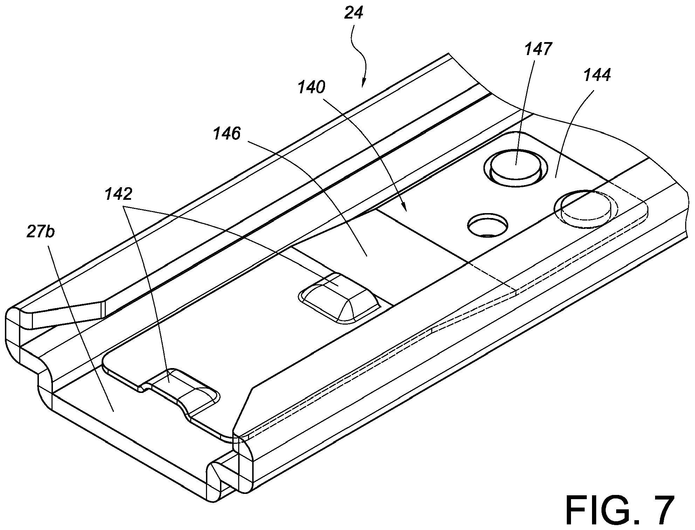

As shown in FIG. 4 and FIG. 7, the slide rail assembly 20 further comprises an engaging member 140 adjacent to the second end portion 27b of the second rail 24, wherein the engaging member 140 comprises at least one positioning portion 142. It is noted that the positioning portion 142 may be a protruding post, but the present invention is not limited thereto; for example, the positioning portion 142 also may be other types of protrusion. Preferably, there are two positioning portions 142. Moreover, in a preferred embodiment, the engaging member 140 comprises a base plate 144 and an elastic portion 146. The elastic portion 146 bends from the base plate 144 and thus is able to provide an elastic force. The base plate 144 may be mounted on the second rail 24 by means of at least one connection member 147, wherein the connection member 147 may be integrated on the second rail 24, but the present invention is not limited thereto; for example, the connection member 147 also may be an independent component mounted on the second rail 24. The positioning portion 142 is located adjacent to the elastic portion 146.

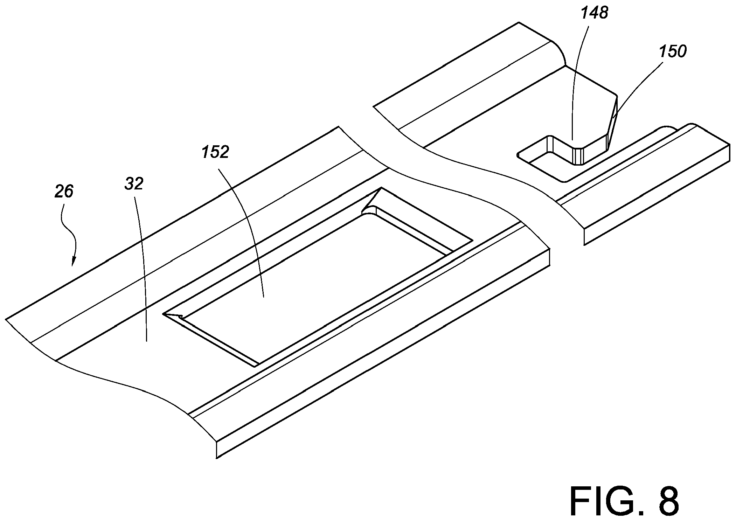

As shown in FIG. 4 and FIG. 8, the third rail 26 is longitudinally and movably connected to the second rail 24. More specifically, the third rail 26 is received in and movable along the second longitudinal channel 29 of the second rail 24. The third rail 26 comprises an upper wall 70 and a lower wall 72 in addition to the first longitudinal portion 32 and the second longitudinal portion 34, wherein the first longitudinal portion 32 and the second longitudinal portion 34 extend between the upper wall 70 and the lower wall 72.

The first longitudinal portion 32 of the third rail 26 comprises a hook portion 148. In a preferred embodiment, the third rail 26 further comprises a guiding slant 150 adjacent to the hook portion 148, wherein the hook portion 148 is configured to engage with the contact portion 110 of the actuating member 100. The third rail 26 further comprises an opening 152. In a preferred embodiment, the opening 152 is located at the first longitudinal portion 32 of the third rail 26, but the present invention is not limited thereto.

In addition, as shown in FIG. 3 and FIG. 4, the operating member 30 is connected to the third rail 26. In a preferred embodiment, the operating member 30 comprises a base plate portion 31 connected to the second longitudinal portion 34 of the third rail 26, an elastic plate 33 bending from the base plate portion 31 and for providing an elastic force, and a handle portion 37 connected to the elastic plate 33. The elastic plate 33 comprises an engaging portion 39 corresponding to the fixing portion 43 of the first rail 22. The engaging portion 39 is a protrusion and the fixing portion 43 of the first rail 22 is a hole in the illustrative embodiment here; however, the fixing portion 43 of the first rail 22 may be a protrusion and the engaging portion 39 may be a hole in another embodiment not shown. Accordingly, when the third rail 26 is retracted back to a retracted position with respect to the first rail 22 (as in FIG. 1), the engaging portion 39 of the operating member 30 engages with the fixing portion 43 of the first rail 22 by the elastic force provided by the elastic plate 33; on the other hand, when the user wishes to move the third rail 26 along the extending direction, the elastic plate 33 may be slightly bent by means of the elasticity of the elastic plate 33 to disengage the engaging portion 39 from the fixing portion 43 of the first rail 22, thus allowing the user to move the third rail 26 along the extending direction by means of the handle portion 37 of the operating member 30.

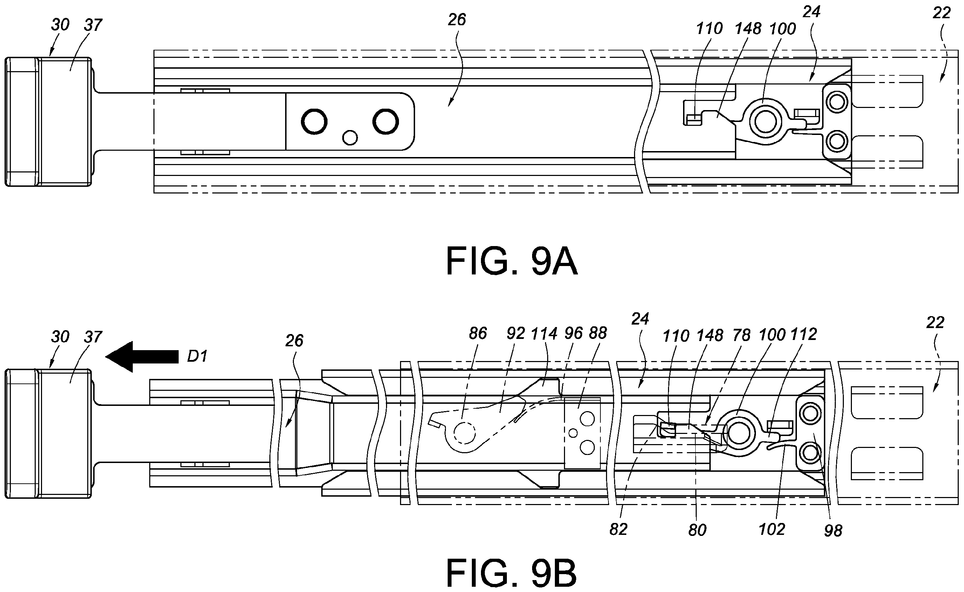

FIG. 9A to FIG. 13 are schematic views of the operation of the slide rail assembly 20.

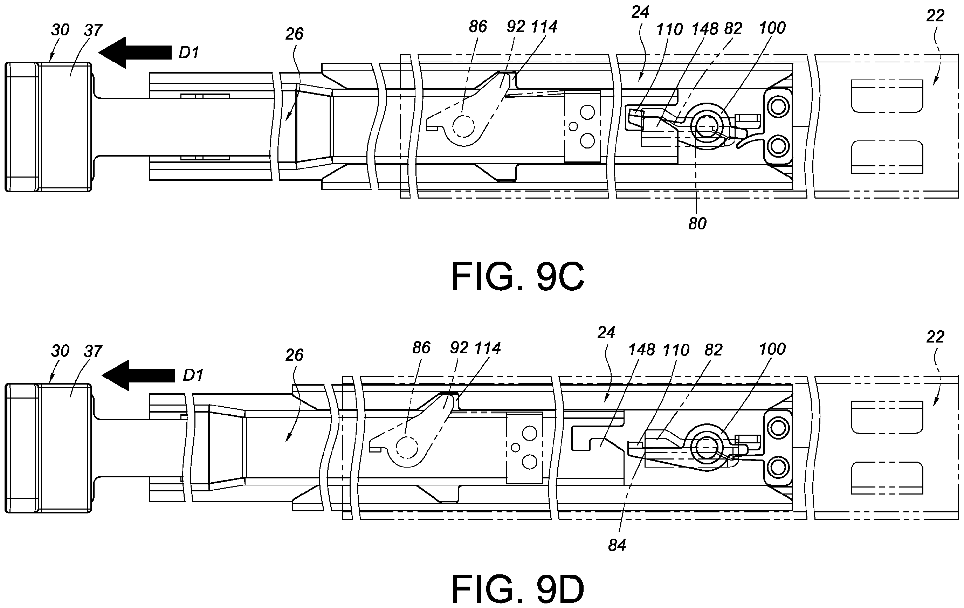

As shown in FIG. 9A to FIG. 9D, when the user pulls the third rail 26, by means of the handle portion 37 of the operating member 30, along an extending direction D1 with respect to the first rail 22 with the contact portion 110 of the actuating member 100 correspondingly engaging with the hook portion 148 of the third rail 26 (as in FIG. 9A and 9B), the second rail 24 is synchronously moved along with the third rail 26; however, when the second rail 24 is moved to a predetermined position with respect to the first rail 22, the contact portion 110 of the actuating member 100 is correspondingly guided by the guiding portion 78 of the first rail 22 and finally disengaged from the hook portion 148 of the third rail 26 (as in FIG. 9C and 9D). Specifically, the contact portion 110 of the actuating member 100 is guided by the horizontal section 80 of the guiding portion 78 and then moved upward along the inclining section 82 of the guiding portion 78; wherein when the contact portion 110 of the actuating member 100 is moved along the inclining section 82, the actuating member 100 rotates by an angle by means of the tail portion 112 pressing against the contact section 102 of the fixing member 98 (as in FIG. 9B). Subsequently, the contact portion 110 of the actuating member 100 is moved to a distal edge of the inclining section 82 and thus lifted to disengage from the hook portion 148 of the third rail 26 (as in FIG. 9C). Preferably, at least one of the tail portion 112 of the actuating member 100 and the contact section 102 of the fixing member 98 is of flexible materials to facilitate rotation of the actuating member 100, thus allowing the contact portion 110 of the actuating member 100 to disengage from the hook portion 148 of the third rail 26 smoothly. Consequently, the contact portion 110 of the actuating member 100 is completely separated from the third rail 26 and blocked by the blocking wall 84 of the guiding portion 78 (as in FIG. 9D) when the third rail 26 is further pulled along the extending direction D1.

Moreover, as shown in FIG. 9B and FIG. 9C, the leg portion 92 of the swinging member 86 is guided into the indention portion 114 of the second rail 24 (as in FIG. 9B) and then pressed against the indention portion 114 of the second rail 24 (as in FIG. 9C) in response to the elastic force generated by the elastic guiding portion 96 of the assisting member 88. In other words, the leg portion 92 of the swinging member 86 is engaged with the indention portion 114 of the second rail 24. As such, the second rail 24 is positioned with respect to the first rail 22.

As shown in FIG. 9D, as the contact portion 110 of the actuating member 100 is blocked by the blocking wall 84 of the guiding portion 78 of the first rail 22 and the leg portion 92 of the swinging member 86 is engaged with the indention portion 114 of the second rail 24, the second rail 24 is no longer synchronously moved along with the third rail 26. However, the third rail 26 may continue to move along the extending direction D1.

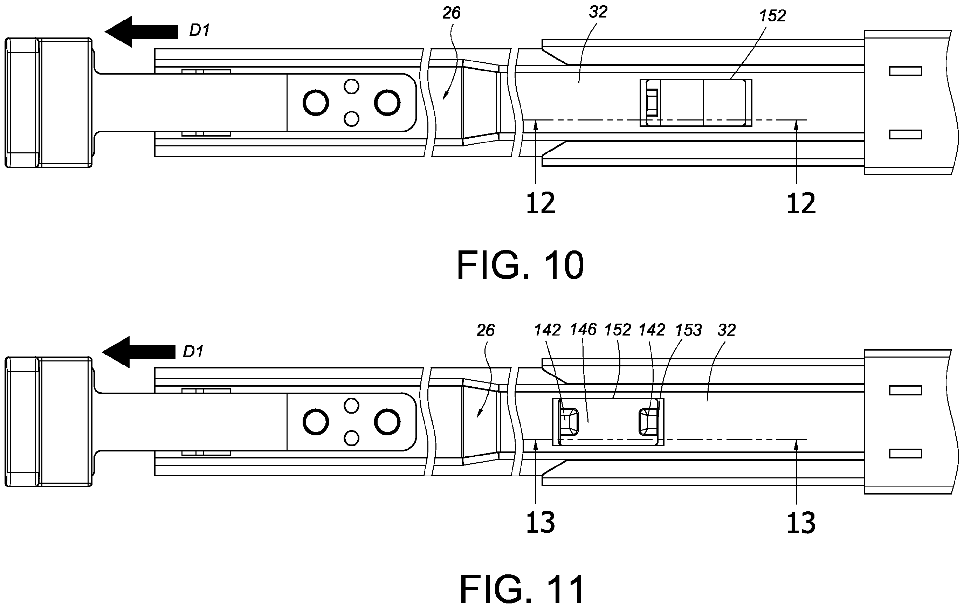

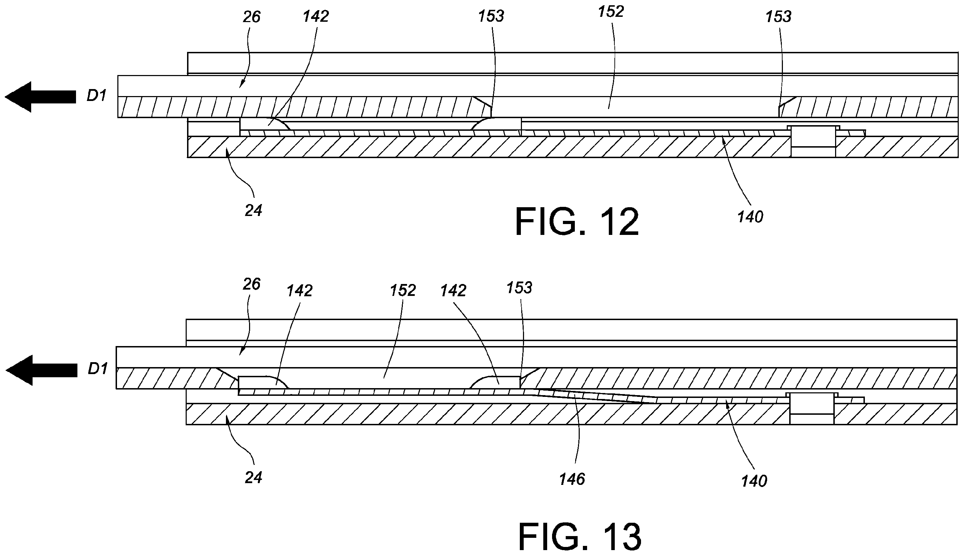

As shown in FIG. 10 to FIG. 13, as the third rail 26 continues to move along the extending direction D1, the elastic portion 146 of the engaging member 140 that is capable of bending elastically is pressed between the second rail 24 and the third rail 26 and is in an elastic force accumulation state (as in FIG. 10 and FIG. 12) before the third rail 26 moves to an extended position. Once the third rail 26 further moves to the extended position, the elastic portion 146 releases the elastic force so that the positioning portion 142 of the engaging member 140 enters the opening 152 of the first longitudinal portion 32 of the third rail 26 and is engaged with an opening edge 153 of the opening 152 (as in FIG. 11 and FIG. 13).

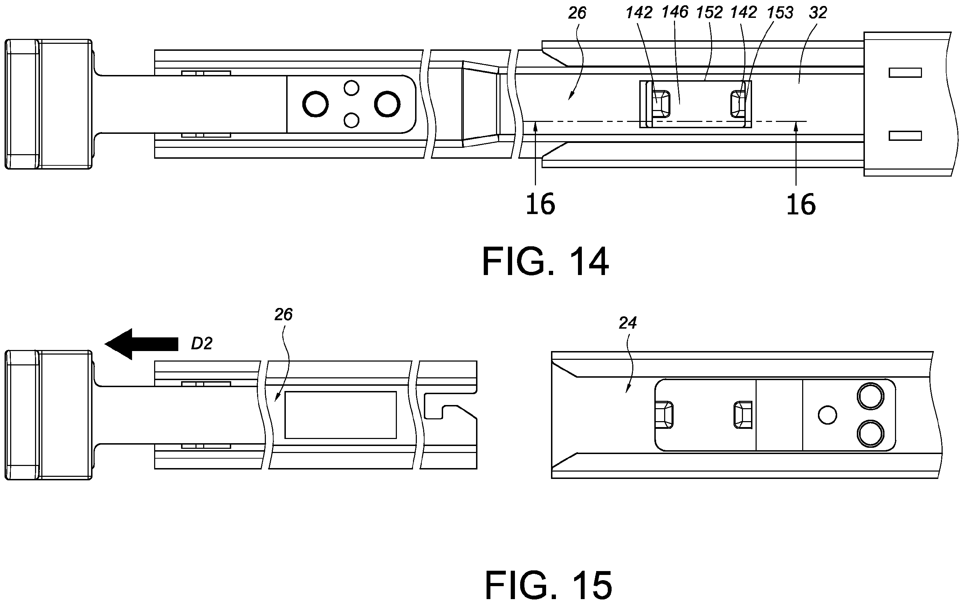

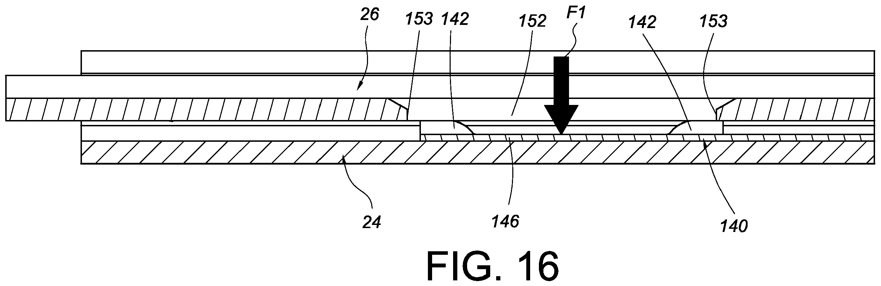

As shown in FIG. 14 to FIG. 16, to dismount the third rail 26 from the second rail 24 when the third rail 26 is at the extended position, the user may apply a force F1 from the opening 152 of the third rail 26 to the elastic portion 146 of the engaging member 140 (as in FIG. 16) so that the positioning portion 142 of the elastic portion 146 is separated from the opening 152 and no longer engages with the opening edge 153. As such, the third rail 26 may be drawn in a dismounting direction D2 (as in FIG. 15) to dismount the third rail 26 from the second rail 24.

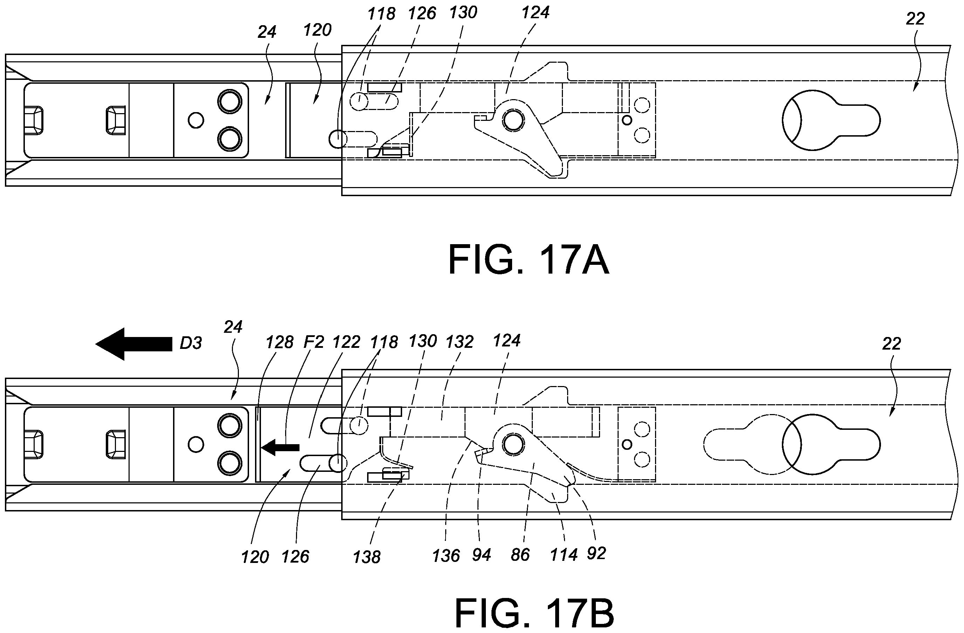

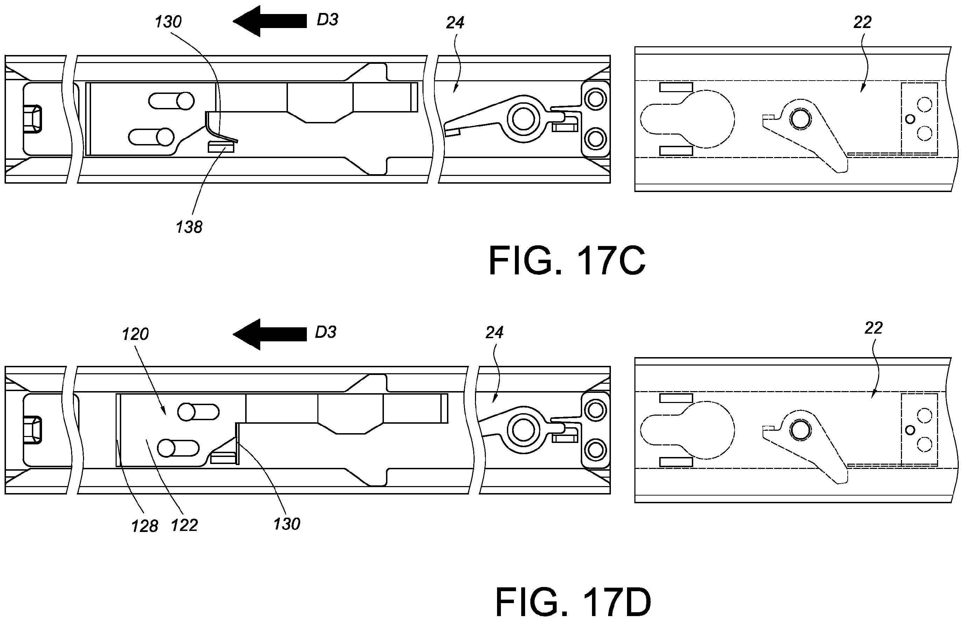

As shown in FIG. 17A to FIG. 17D, after the third rail 26 is dismounted, the user may further dismount the second rail 24 from the first rail 22. The user may apply a force F2 (as in FIG. 17B) to pull the operating portion 128 of the releasing member 120 so that the moving portion 122 of the releasing member 120 moves with respect to the restricting member 118 by means of the longitudinal groove 126. As such, the disengaging portion 124 of the releasing member 120 is driven to move along with the moving portion 122 so that the disengaging edge 136 correspondingly presses against a portion of the swinging member 86 (such as the extended side portion 94) to disengage the leg portion 92 of the swinging member 86 from the indention portion 114 of the second rail 24 (meanwhile, the flexible member 130 is bent by the force applied from the blocking member 138). As such, the second rail 24 may be drawn in a dismounting direction D3 to dismount the second rail 24 from the first rail 22 (as in FIG. 17C). The flexible member 130 returns the releasing member 120 to its initial state (as in FIG. 17D) once the user ceases applying the force F2 to the operating portion 128.

As illustrated in FIG. 14 to FIG. 17D, the third rail 26 and the second rail 24 of the slide rail assembly 20 may both be dismounted so that the user may carry out replacement of the chassis (such as a server chassis) or replacement or maintenance of the slide rail assembly 20.

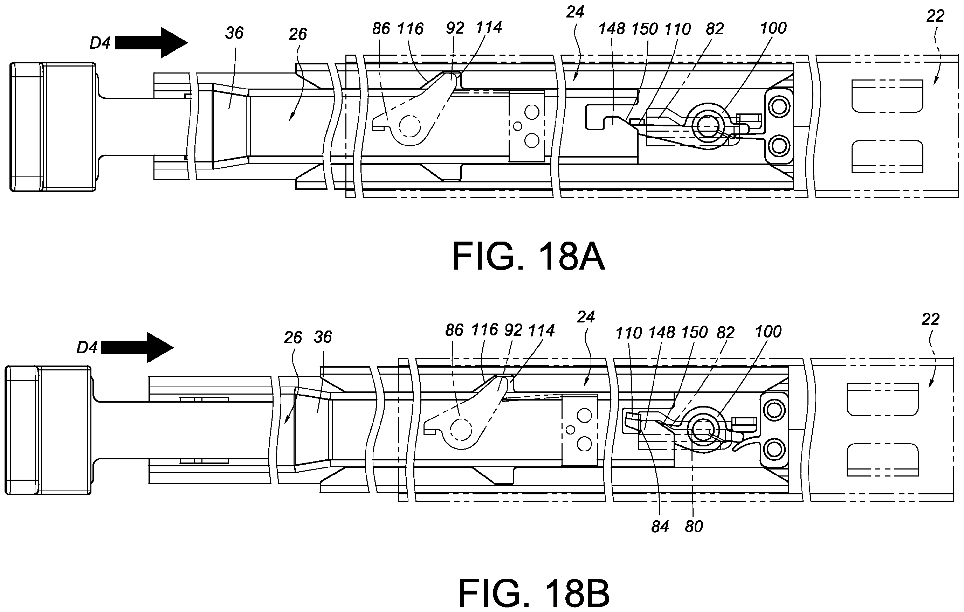

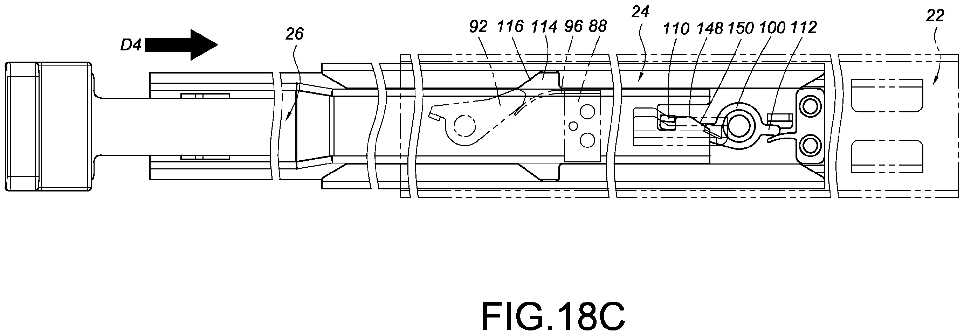

Moreover, as shown in FIG. 18A to FIG. 18C, to retract the third rail 26 from the extended position (as in FIG. 11) along a retracting direction D4, the user may apply a force to press the elastic portion 146 of the engaging member 140 (as in FIG. 16) again and simultaneously push the third rail 26 along the retracting direction D4 so that the slant portion 36 of the third rail 26 may press against the second rail 24, thus allowing the third rail 26 and the second rail 24 to be retracted with respect to the first rail 22. When the second rail 24 is moved to a position, the guiding slant 150 of the hook portion 148 of the third rail 26 correspondingly lifts the contact portion 110 of the actuating member 100 so that the contact portion 110 of the actuating member 100 is moved away from the blocking wall 84 and back to the distal edge of the inclining section 82 of the guiding portion 78 of the first rail 22 (as in FIG. 18B). Furthermore, the slant 116 of the second rail 24 presses against the leg portion 92 of the swinging member 86 so that the leg portion 92 deviates and finally disengages from the indention portion 114 (as in FIG. 18C). As such, the contact portion 110 of the actuating member 100 may be guided by the guiding portion 78 of the first rail 22 again and moved back to engage with the hook portion 148 of the third rail 26, so that third rail 26 and the second rail 24 may be retracted to a retracted state with respect to the first rail 22 (as in FIG. 9A).

While the invention has been described by way of example and in terms of the preferred embodiments, it is to be understood that the invention defined by the appended claims is not limited to the disclosed embodiments.

## Claims

1. A slide rail assembly (20), comprising:
a first rail (22), comprising a guiding portion (78); and
a second rail (24), longitudinally and movably connected to the first rail (22);
an actuating member (100), movably connected to the second rail (24) and comprising a contact portion (110); and
a third rail (26), longitudinally and movably connected to the second rail (24) and comprising a hook portion (148),
wherein when the third rail (26) is pulled with respect to the first rail (22) along an extending direction with the contact portion (110) of the actuating member (100) engaging with the hook portion (148) of the third rail (26), the second rail (24) is synchronously moved along with the third rail (26), and wherein when the second rail (24) is moved along the extending direction to a predetermined position with respect to the first rail (22), the actuating member (100) rotates by an angle by guiding means of the guiding portion (78) of the first rail (22) and thereby disengages the contact portion (110) of the actuating member (100) from the hook portion (148) of the third rail (26), **characterized in that** the guiding portion (78) of the first rail (22) comprises a horizontal section (80) and an inclining section (82) extending from the horizontal section (80), and wherein when the second rail (24) is moved to the predetermined position with respect to the first rail (22), the actuating member (100) is guided from the horizontal section (80) to the inclining section (82) and thereby rotates by the angle to disengage the contact portion (110) of the actuating member (100) from the hook portion (148) of the third rail (26).

2. The slide rail assembly (20) as claimed in claim 1, wherein the guiding portion (78) further comprises a blocking wall (84) adjacent to the inclining section (82) to further block the contact portion (110) of the actuating member (100) after the actuating member (100) is guided from the horizontal section (80) to the inclining section (82).

3. The slide rail assembly (20) as claimed in claim 1, wherein the second rail (24) comprises a protrusion portion (104) and the slide rail assembly (20) further comprises a fixing member (98) connected to the second rail (24), and wherein the fixing member (98) comprises a contact section (102) corresponding to the protrusion portion (104) of the second rail (24) and the actuating member (100) further comprises a tail portion (112) located between the contact section (102) of the fixing member (98) and the protrusion portion (104) of the second rail (24).

4. The slide rail assembly (20) as claimed in claim 1, further comprising:
a swinging member (86), pivotally connected to the first rail (22) and comprising a leg portion (92), wherein the second rail (24) comprises an indention portion (114) for the leg portion (92) to engage with; and
an assisting member (88), comprising an elastic guiding portion (96) contacting the swinging member (86),
wherein when the second rail (24) moves to the predetermined position, the swinging member (86) presses the leg portion (92) against the indention portion (114) of the second rail (24) by an elastic force generated by the elastic guiding portion (96).

5. The slide rail assembly (20) as claimed in claim 4, further comprising:
at least one restricting member (118), attached to the second rail (24); and
a releasing member (120), mounted to the second rail (24) and comprising a moving portion (122) and a disengaging portion (124), wherein one of the moving portion (122) and the disengaging portion (124) comprises at least one longitudinal groove (126) interacting with the at least one restricting member (118), and wherein the disengaging portion (124) interacts with a portion of the swinging member (86),
wherein when the releasing member (120) is pulled with respect to the at least one restricting member (118) after engagement of the leg portion (92) of the swinging member (86) with the indention portion (114) of the second rail (24), the swinging member (86) is moved by means of the disengaging portion (124) of the releasing member (120) to disengage the leg portion (92) of the swinging member (86) from the indention portion (114) of the second rail (24).

6. The slide rail assembly (20) as claimed in claim 1, further comprising:
a fixing member (98), connected to the second rail (24) and comprising a contact section (102), and
a swinging member (86), movably connected to the longitudinally extending body (42) of the first rail (22) and comprising a leg portion (92),
wherein the first rail (22) comprises an upper wall (38), a lower wall (40), and a longitudinally extending body (42) extending between the upper wall (38) and the lower wall (40) of the first rail (22), wherein the guiding portion (78) is configured on the longitudinally extending body (42) of the first rail (22) and further comprises a blocking wall (84) adjacent to the inclining section (82);
wherein the second rail (24) comprises an upper wall (52), a lower wall (54), a longitudinally extending body (56) extending between the upper wall (52) and the lower wall (54) of the second rail (24), and a protrusion portion (104) located at the longitudinally extending body (56) of the second rail (24) and corresponding to the contact section (102) of the fixing member (98), wherein one of the upper wall (52) and the lower wall (54) of the second rail (24) comprises an indention portion (114) corresponding to the leg portion (92) of the swinging member (86);
wherein the actuating member (100) further comprises a tail portion (112), wherein the contact portion (110) of the actuating member (100) corresponds in configuration to the guiding portion (78) of the first rail (22) and the hook portion (148) of the third rail (26), and wherein the tail portion (112) of the actuating member (100) is located between the contact section (102) of the fixing member (98) and the protrusion portion (104) of the second rail (24);
wherein when the second rail (24) is moved to a position corresponding to the guiding portion (78) of the first rail (22), the contact portion (110) of the actuating member (100) is successively guided by the horizontal section (80) and the inclining section (82) of the guiding portion (78) of the first rail (22), and wherein when the contact portion (110) of the actuating member (100) is guided by the inclining section (82), the actuating member (100) rotates by means of the tail portion (112) pressing against the contact section (102) of the fixing member (98) so that the contact portion (110) of the actuating member (100) disengages from the hook portion (148) of the third rail (26) and is then guided to and blocked by the blocking wall (84) of the guiding portion (78); and
wherein when the second rail (24) is synchronously moved along with the third rail (26) to the predetermined position along the extending direction, the leg portion (92) of the swinging member (86) enters the indention portion (114) of the second rail (24).

7. The slide rail assembly (20) as claimed in claim 3 or 6, wherein the second rail (24) has a first end portion (27a), and wherein the fixing member (98) and the actuating member (100) are adjacent to the first end portion (27a) of the second rail (24).

8. The slide rail assembly (20) as claimed in claim 3 or 6, wherein the second rail (24) has a second end portion (27b) and the slide rail assembly (20) further comprises an engaging member (140) adjacent to the second end portion (27b) of the second rail (24), and wherein the engaging member (140) comprises a positioning portion (142) and the third rail (26) further comprises an opening (152) corresponding to the positioning portion (142) of the engaging member (140) so that the positioning portion (142) of the engaging member (140) engages with and positions at the opening (152) of the third rail (26) when the third rail (26) moves with respect to the second rail (24) to an extended position.

9. The slide rail assembly (20) as claimed in claim 8, wherein the engaging member (140) comprises a base plate (144) and an elastic portion (146) bending from the base plate (144), and wherein the positioning portion (142) is located at the elastic portion (146).

10. The slide rail assembly (20) as claimed in claim 6, further comprising:
at least one restricting member (118), attached to the second rail (24); and
a releasing member (120), mounted to the longitudinally extending body (56) of the second rail (24) and adjacent to the indention portion (114) of the second rail (24), the releasing member (120) comprising a moving portion (122) and a disengaging portion (124), wherein one of the moving portion (122) and the disengaging portion (124) comprises at least one longitudinal groove (126) corresponding to the at least one restricting member (118), and wherein the disengaging portion (124) corresponds to a portion of the swinging member (86),
wherein when the moving portion (122) is operated after engagement of the leg portion (92) of the swinging member (86) with the indention portion (114) of the second rail (24), the disengaging portion (124) is driven to move the portion of the swinging member (86) so that the leg portion (92) of the swinging member (86) is disengaged from the indention portion (114) of the second rail (24) again.

11. The slide rail assembly (20) as claimed in claim 6, wherein the third rail (26) further comprises a guiding slant (150) adjacent to the hook portion (148), and wherein when the third rail (26) is retracted along a retracting direction, the contact portion (110) of the actuating member (100) is pressed back to engage with the hook portion (148) of the third rail (26) by the guiding slant (150) of the third rail (26).

12. The slide rail assembly (20) as claimed in claim 11, wherein the indention portion (114) of the second rail (24) comprises a slant (116), and wherein when the third rail (26) is retracted along the retracting direction, the slant (116) presses against the leg portion (92) of the swinging member (86) so that the leg portion (92) deviates and leaves the indention portion (114) of the second rail (24).

13. The slide rail assembly (20) as claimed in claim 6, further comprising an operating member (30) connected to the third rail (26) to be operated to move the third rail (26) along the extending direction, wherein the longitudinally extending body (42) of the first rail (22) comprises a fixing portion (43), wherein the operating member (30) comprises a base plate portion (31) connected to the third rail (26), an elastic plate (33) bending from the base plate portion (31) for providing an elastic force, and a handle portion (37) connected to the elastic plate (33), wherein the elastic plate (33) comprises an engaging portion (39) corresponding to the fixing portion (43) of the longitudinally extending body (42) of the first rail (22), and wherein when the third rail (26) is retracted to a retracted position with respect to the first rail (22), the engaging portion (39) of the elastic plate (33) engages with the fixing portion (43) by the elastic force provided by the elastic plate (33).

## Patentansprüche

1. Eine Laufschienenmontage (20), umfassend:
eine erste Schiene (22), umfassend ein Führungsteil (78); und
eine zweite Schiene (24), die der Länge nach und beweglich an der ersten Schiene (22) befestigt ist;
ein Betätigungsglied (100), das beweglich an der zweiten Schiene (24) befestigt ist und einen Kontaktteil (110) umfasst; und
eine dritte Schiene (26), die der Länge nach und beweglich an der zweiten Schiene (24) befestigt ist und einen Haken (148) aufweist,
worin beim Ziehen an der dritten Schiene (26) in Bezug zur ersten Schiene (22) einer Ausfahrrichtung entlang mit dem Kontaktteil (110) des Betätigungsglieds (100), das mit dem Haken (148) der dritten Schiene (26) in Eingriff ist, die zweite Schiene (24) gleichzeitig mit der dritten Schiene (26) bewegt wird; beim Bewegen der zweiten Schiene (24) der Ausfahrrichtung entlang in eine vorbestimmte Position in Bezug auf die erste Schiene (22) das Betätigungsglied (100) mit Führungsmitteln des Führungsteils (78) der ersten Schiene (22) um einen Winkel rotiert wird und dadurch der Kontaktteil (110) des Betätigungsglieds (100) aus dem Haken (148) der dritten Schiene (26) ausgerückt wird; **dadurch gekennzeichnet, dass** der Führungsteil (78) der ersten Schiene (22) einen horizontalen Teil (80) und einen neigenden Teil (82), der sich vom horizontalen Teil (80) erstreckt, umfasst; beim Bewegen der zweiten Schiene (24) in eine vorbestimmte Position in Bezug auf die erste Schiene (22) das Betätigungsglied (100) mit dem horizontalen Teil (80) zum neigenden Teil (82) geführt wird und dadurch um den Winkel rotiert wird, um den Kontaktteil (110) des Betätigungsglieds (100) aus dem Haken (148) der dritten Schiene (26) auszurücken.

2. Die Laufschienenmontage (20) nach Anspruch 1, worin der Führungsteil (78) weiter eine Sperrwand (84) umfasst, die an den neigenden Teil (82) angrenzt, um den Kontaktteil (110) des Betätigungsglieds (100) weiter zu blockieren, nachdem das Betätigungsglied (100) vom horizontalen Teil (80) zum neigenden Teil (82) geführt wurde.

3. Die Laufschienenmontage (20) nach Anspruch 1, worin die zweite Schiene (24) einen vorstehenden Teil (104) umfasst und die Lautschienenmontage (20) weiter ein Befestigungsglied (98) umfasst, das an der zweiten Schiene (24) befestigt ist; das Befestigungsglied (98) einen Kontaktabschnitt (102) in Übereinstimmung mit dem vorstehenden Teil (104) der zweiten Schiene (24) aufweist und das Betätigungsglied (100) weiter mit einem Schwanzteil (112) gebildet ist, der zwischen dem Kontaktabschnitt (102) des Befestigungsglieds (98) und dem vorstehenden Teil (104) der zweiten Schiene (24) vorgesehen ist.

4. Die Laufschienenmontage (20) nach Anspruch 1, weiter umfassend:
ein Schwenkglied (86), das drehgelenkig an der ersten Schiene (22) montiert ist und ein Schenkelstück (92) umfasst, worin die zweite Schiene (24) einen Einrückteil (114) umfasst, mit dem das Schenkelstück (92) in Eingriff gebracht wird; und
ein Stützglied (88), das einen elastischen Führungsteil (96) umfasst, der mit dem Schwenkglied (86) in Kontakt kommt;
worin beim Bewegen der zweiten Schiene (24) in die vorbestimmte Position das Schwenkglied (86) das Schenkelstück (92) mit einer elastische Kraft, die mit dem elastischen Führungsteil (96) erzeugt wird, gegen den Einrückteil (114) der zweiten Schiene (24) andrückt.

5. Die Laufschienenmontage (20) nach Anspruch 4, weiter umfassend:
mindestens einen Begrenzteil (118), der an der zweiten Schiene (24) befestigt ist; und
ein Auslöseglied (120), das an der zweiten Schiene (24) montiert ist und einen beweglichen Teil (122) und einen Ausrückteil (124) umfasst, worin einer der beweglichen Teile (122) und der Ausrückteile (124) mindestens eine Längsnut (126) aufweisen, die mit dem mindestens einen Begrenzteil (118) zusammenwirkt; der Ausrückteil (124) mit einem Teil des Schwenkglieds (86) zusammenwirkt,
worin beim Ziehen am Auslöseglied (120) in Bezug auf den mindestens einen Begrenzteil (118), nachdem das Schenkelstück (92) des Schwenkglieds (86) mit dem Einrückteil (114) der zweiten Schiene (24) in Eingriff gebracht wurde, das Schwenkglied (86) mit dem Ausrückteil (124) des Auslöseglieds (120) bewegt wird, um das Schenkelstück (92) des Schwenkglieds (86) aus dem Einrückteil (114) der zweiten Schiene (24) auszurücken.

6. Die Laufschienenmontage (20) nach Anspruch 1, weiter umfassend:
ein Befestigungsglied (98), das an der zweiten Schiene (24) befestigt ist und einen Kontaktabschnitt (102) aufweist; und
ein Schwenkglied (86), das beweglich am länglich erstreckenden Körper (42) der ersten Schiene (22) befestigt ist und mit einem Schenkelstück (92) gebildet ist;
worin die erste Schiene (22) eine obere Wand (38), eine untere Wand (40) und einen länglich erstreckenden Körper (42), der sich zwischen der oberen Wand (38) und der unteren Wand (40) der ersten Schiene (22) erstreckt, umfasst, worin der Führungsteil (78) am länglich erstreckenden Körper (42) der ersten Schiene (22) konfiguriert ist und weiter eine Sperrwand (84), die am neigenden Teil (82) angrenzt, umfasst;
worin die zweite Schiene (24) eine obere Wand (52), eine untere Wand (54), einen länglich erstreckenden Körper (56), der sich zwischen der oberen Wand (52) und der unteren Wand (54) der zweiten Schiene (24) erstreckt, umfasst, und ein vorstehender Teil (104) am länglich erstreckenden Körper (56) der zweiten Schiene (24) und in Übereinstimmung mit dem Kontaktabschnitt (102) des Befestigungsglieds (98) vorgesehen ist; eine der oberen Wände (52) und der unteren Wände (54) der zweiten Schiene (24) einen Einrückteil (114) in Übereinstimmung mit dem Schenkelstück (92) des Schwenkglieds (86) aufweisen;
worin das Betätigungsglied (100) weiter mit einem Schwanzteil (112) gebildet ist; die Konfiguration des Kontaktteils (110) des Betätigungsglieds (100) dem Führungsteil (78) der ersten Schiene (22) und dem Haken (148) der dritten Schiene (26) entspricht; der Schwanzteil (112) des Betätigungsglieds (100) zwischen dem Kontaktabschnitt (102) des Befestigungsglieds (98) und dem vorstehenden Teil (104) der zweiten Schiene (24) vorgesehen ist;
worin beim Bewegen der zweiten Schiene (24) in eine Position in Übereinstimmung mit dem Führungsteil (78) der ersten Schiene (22) der Kontaktteil (110) des Betätigungsglieds (100) nachfolgend mit dem horizontalen Teil (80) und dem neigenden Teil (82) des Führungsteils (78) der ersten Schiene (22) geführt wird; beim Führen des Kontaktteils (110) des Betätigungsglieds (100) mit dem neigenden Teil (82) das Betätigungsglied (100) mit dem Schwanzteil (112), der gegen den Kontaktabschnitt (102) des Befestigungsglieds (98) drückt, rotiert wird, so dass der Kontaktteil (110) des Betätigungsglieds (100) aus dem Haken (148) der dritten Schiene (26) ausgerückt und danach zur Sperrwand (84) des Führungsteils (78) geführt und von dieser blockiert wird; und
worin beim gleichzeitigen Bewegen der zweiten Schiene (24) der dritten Schiene (26) entlang in Ausfahrrichtung in die vorbestimmte Position das Schenkelstück (92) des Schwenkglieds (86) in den Einrückteil (114) der zweiten Schiene (24) gebracht wird.

7. Die Laufschienenmontage (20) nach Anspruch 3 oder 6, worin die zweite Schiene (24) einen ersten Endteil (27a) aufweist und das Befestigungsglied (98) und das Betätigungsglied (100) an diesen ersten Endteil (27a) der zweiten Schiene (24) angrenzen.

8. Die Laufschienenmontage (20) nach Anspruch 3 oder 6, worin die zweite Schiene (24) einen zweiten Endteil (27b) aufweist und die Lautschienenmontage (20) weiter ein Einrückglied (140) umfasst, das an den zweiten Endteil (27b) der zweiten Schiene (24) angrenzt; das Einrückglied (140) einen Positionierteil (142) umfasst und die dritte Schiene (26) weiter eine Öffnung (152) in Übereinstimmung mit dem Positionierteil (142) des Einrückglieds (140) aufweist, so dass der Positionierteil (142) des Einrückglieds (140) mit der Öffnung (152) der dritten Schiene (26) in Eingriff gebracht und in dieser positioniert wird, wenn die dritte Schiene (26) in Bezug auf die zweite Schiene (24) in eine ausgestreckte Position bewegt wird.

9. Die Laufschienenmontage (20) nach Anspruch 8, worin das Einrückglied (140) ein Grundplättchen (144) und einen elastischen Teil (146), der vom Grundplättchen (144) gebogen ist, umfasst; der Positionierteil (142) am elastischen Teil (146) vorgesehen ist.

10. Die Laufschienenmontage (20) nach Anspruch 6, weiter umfassend:
mindestens einen Begrenzteil (118), der an der zweiten Schiene (24) befestigt ist; und
ein Auslöseglied (120), das am länglich erstreckenden Körper (56) der zweiten Schiene (24) und angrenzend am Einrückteil (114) der zweiten Schiene (24) montiert ist; das Auslöseglied (120) einen beweglichen Teil (122) und einen Ausrückteil (124) umfasst, worin einer der beweglichen Teile (122) und der Ausrückteil (124) mindestens eine Längsnut (126) in Übereinstimmung mit dem mindestens einen Begrenzteil (118) aufweisen; der Ausrückteil (124) einem Teil des Schwenkglieds (86) entspricht;
worin beim Betätigen des beweglichen Teils (122), nachdem das Schenkelstück (92) des Schwenkglieds (86) mit dem Einrückteil (114) der zweiten Schiene (24) in Eingriff gebracht wurde, der Ausrückteil (124) angetrieben wird, um den Teil des Schwenkglieds (86) zu bewegen, so dass das Schenkelstück (92) des Schwenkglieds (86) erneut aus dem Einrückteil (114) der zweiten Schiene (24) ausgerückt wird.

11. Die Laufschienenmontage (20) nach Anspruch 6, worin die dritte Schiene (26) weiter eine führende Schräglage (150), die am Haken (148) angrenzt, aufweist, und worin die dritte Schiene (26) einer Einziehrichtung entlang eingezogen wird; der Kontaktteil (110) des Betätigungsglieds (100) zurück gedrückt wird, um mit der führenden Schräglage (150) der dritten Schiene (26) mit dem Haken (148) der dritten Schiene (26) in Eingriff gebracht zu werden.

12. Die Laufschienenmontage (20) nach Anspruch 11, worin der Einrückteil (114) der zweiten Schiene (24) eine Schräglage (116) aufweist, und worin beim Einziehen der dritten Schiene (26) einer Einziehrichtung entlang die Schräglage (116) gegen das Schenkelstück (92) des Schwenkglieds (86) gedrückt wird, so dass das Schenkelstück (92) vom Einrückteil (114) der zweiten Schiene (24) abweicht und diesen verlässt.

13. Die Laufschienenmontage (20) nach Anspruch 6, weiter umfassend ein Betätigungsglied (30), das an der dritten Schiene (26) befestigt wird, wobei die dritte Schiene (26) zum Bewegen der dritten Schiene (26) einer Ausfahrrichtung entlang betätigt wird; der länglich erstreckende Körper (42) der ersten Schiene (22) einen Befestigungsteil (43) umfasst; das Betätigungsglied (30) einen Grundplättchenteil (31), der an der dritten Schiene (26) befestigt ist, umfasst; ein elastisches Plättchen (33) vom Grundplättchenteil (31) gebogen wird, um eine elastische Kraft zu erzeugen; ein Griff (37), der am elastischen Plättchen (33) befestigt ist; das elastische Plättchen (33) einen Einrückteil (39) in Übereinstimmung mit dem Befestigungsteil (43) des länglich erstreckenden Körpers (42) der ersten Schiene (22) umfasst; beim Einziehen der dritten Schiene (26) in eine eingezogene Position in Bezug auf die erste Schiene (22) der Einrückteil (39) des elastischen Plättchens (33) mit der elastischen Kraft, die mit dem elastischen Plättchen (33) erzeugt wird, mit dem Befestigungsteil (43) in Eingriff gebracht wird.

## Revendications

1. Ensemble de glissières (20), **caractérisé par le fait qu'**il comprend :
un premier rail (22), **caractérisé par le fait qu'**il comprend une partie de guidage (78) ; et
un deuxième rail (24), raccordé de manière longitudinale et mobile au premier rail (22) ;
un élément d'actionnement (100), raccordé de manière mobile au deuxième rail (24) et **caractérisé par le fait qu'**il comprend une partie de contact (110) ; et
un troisième rail (26), raccordé de manière longitudinale et mobile au deuxième rail (24) et **caractérisé par le fait qu'**il comprend une partie en forme de crochet (148),
lorsque le troisième rail (26) est retiré par rapport au premier rail (22) le long d'une direction d'extension avec la partie de contact (110) de l'élément d'actionnement (100) s'engageant avec la partie en forme de crochet (148) du troisième rail (26), le deuxième rail (24) est déplacé de manière synchrone tout comme le troisième rail (26), et lorsque le deuxième rail (24) est déplacé le long de la direction d'extension vers une position prédéfinie par rapport au premier rail (22), l'élément d'actionnement (100) tourne d'un angle par un moyen de guidage de la partie de guidage (78) du premier rail (22) et se désengage par conséquent de la partie de contact (110) de l'élément d'actionnement (100) de la partie en forme de crochet (148) du troisième rail (26), **caractérisé par le fait que** la partie de guidage (78) du premier rail (22) comprend une section horizontale (80) et une section d'inclinaison (82) s'étendant à partir de la section horizontale (80), et lorsque le deuxième rail (24) est déplacé vers la position prédéfinie par rapport au premier rail (22), l'élément d'actionnement (100) est guidé à partir de la section horizontale (80) vers la section d'inclinaison (82) et de ce fait tourne selon l'angle pour désengager la partie de contact (110) de l'élément d'actionnement (100) de la partie en forme de crochet (148) du troisième rail (26).

2. Ensemble de glissières (20) selon la revendication 1, **caractérisé par le fait que** la partie de guidage (78) comprend en outre une paroi de blocage (84) adjacente à la section d'inclinaison (82) pour mieux bloquer la partie de contact (110) de l'élément d'actionnement (100) une fois que l'élément d'actionnement (100) est guidé à partir de la section horizontale (80) vers la section d'inclinaison (82).

3. Ensemble de glissières (20) selon la revendication 1, **caractérisé par le fait que** le deuxième rail (24) comprend une partie en saillie (104) et **caractérisé par le fait que** l'ensemble de glissières (20) comprend en outre un élément fixateur (98) raccordé au deuxième rail (24), l'élément fixateur (98) comprend une section de contact (102) correspondant à la partie en saillie (104) du deuxième rail (24) et **caractérisé par le fait que** l'élément d'actionnement (100) comprend en outre une partie caudale (112) située entre la section de contact (102) de l'élément fixateur (98) et la partie en saillie (104) du deuxième rail (24).

4. Ensemble de glissières (20) selon la revendication 1, **caractérisé par le fait qu'**il comprend en outre :
un élément pivotant (86), raccordé de manière pivotante au premier rail (22) et **caractérisé par le fait qu'**il comprend une partie de jambe (92), le deuxième rail (24) comprend une partie en indentation (114) pour engager la partie de jambe (92) ; et
un élément d'aide (88), **caractérisé par le fait qu'**il comprend une partie élastique de guidage (96) en contact avec l'élément pivotant (86),
lorsque le deuxième rail (24) se déplace vers la position prédéfinie, l'élément pivotant (86) pousse la partie de jambe (92) contre la partie en indentation (114) du deuxième rail (24) grâce à une force élastique générée par la partie élastique de guidage (96).

5. Ensemble de glissières (20) selon la revendication 4, **caractérisé par le fait qu'**il comprend en outre :
au moins un élément limiteur (118), fixé sur le deuxième rail (24) ; et
un élément de libération (120), monté sur le deuxième rail (24) et **caractérisé par le fait qu'**il comprend une partie mobile (122) et une partie de désengagement (124), soit la partie mobile (122) soit la partie de désengagement (124) comprend au moins une rainure longitudinale (126) en interaction avec le ou les éléments limiteurs (118), la partie de désengagement (124) interagit avec une partie de l'élément pivotant (86),
lorsque l'élément de libération (120) est retiré par rapport au ou aux éléments limiteurs (118) après engagement de la partie de jambe (92) de l'élément pivotant (86) avec la partie en indentation (114) du deuxième rail (24), l'élément pivotant (86) est déplacé au moyen de la partie de désengagement (124) de l'élément de libération (120) pour désengager la partie de jambe (92) de l'élément pivotant (86) de la partie en indentation (114) du deuxième rail (24).

6. Ensemble de glissières (20) selon la revendication 1, **caractérisé par le fait qu'**il comprend en outre :
un élément fixateur (98), raccordé au deuxième rail (24) et **caractérisé par le fait qu'**il comprend une section de contact (102), et
un élément pivotant (86), raccordé de manière mobile au corps s'étendant de manière longitudinale (42) du premier rail (22) et **caractérisé par le fait qu'**il comprend une partie de jambe (92),
le premier rail (22) comprend une paroi supérieure (38), une paroi inférieure (40), et un corps s'étendant de manière longitudinale (42) s'étendant entre la paroi supérieure (38) et la paroi inférieure (40) du premier rail (22), la partie de guidage (78) est configurée sur le corps s'étendant de manière longitudinale (42) du premier rail (22) et **caractérisée par le fait qu'**elle comprend en outre une paroi de blocage (84) adjacente à la section d'inclinaison (82) ;
le deuxième rail (24) comprend une paroi supérieure (52), une paroi inférieure (54), un corps s'étendant de manière longitudinale (56) s'étendant entre la paroi supérieure (52) et la paroi inférieure (54) du deuxième rail (24), et une partie en saillie (104) située sur le corps s'étendant de manière longitudinale (56) du deuxième rail (24) et correspondant à la section de contact (102) de l'élément fixateur (98), soit la paroi supérieure (52) soit la paroi inférieure (54) du deuxième rail (24) comprend une partie en indentation (114) correspondant à la partie de jambe (92) de l'élément pivotant (86) ;
l'élément d'actionnement (100) **caractérisé par le fait qu'**il comprend en outre une partie caudale (112), la partie de contact (110) de l'élément d'actionnement (100) correspond en configuration à la partie de guidage (78) du premier rail (22) et à la partie en forme de crochet (148) du troisième rail (26), la partie caudale (112) de l'élément d'actionnement (100) est située entre la section de contact (102) de l'élément fixateur (98) et la partie en saillie (104) du deuxième rail (24) ;
lorsque le deuxième rail (24) est déplacé sur une position correspondant à la partie de guidage (78) du premier rail (22), la partie de contact (110) de l'élément d'actionnement (100) est successivement guidée par la section horizontale (80) et la section d'inclinaison (82) de la partie de guidage (78) du premier rail (22), lorsque la partie de contact (110) de l'élément d'actionnement (100) est guidée par la section d'inclinaison (82), l'élément d'actionnement (100) tourne au moyen de la partie caudale (112) appuyant contre la section de contact (102) de l'élément fixateur (98) de sorte que la partie de contact (110) de l'élément d'actionnement (100) se désengage de la partie en forme de crochet (148) du troisième rail (26) et est ensuite guidée vers et bloquée par la paroi de blocage (84) de la partie de guidage (78) ; et
lorsque le deuxième rail (24) est déplacé de manière synchrone tout comme le troisième rail (26) vers la position prédéfinie le long de la direction d'extension, la partie de jambe (92) de l'élément pivotant (86) arrive dans la partie en indentation (114) du deuxième rail (24).

7. Ensemble de glissières (20) selon les revendications 3 ou 6, **caractérisé par le fait que** le deuxième rail (24) comporte une première partie d'extrémité (27a), l'élément fixateur (98) et l'élément d'actionnement (100) sont adjacents à la première partie d'extrémité (27a) du deuxième rail (24).

8. Ensemble de glissières (20) selon les revendications 3 ou 6, **caractérisé par le fait que** le deuxième rail (24) comporte une seconde partie d'extrémité (27b) et l'ensemble de glissières (20) **caractérisé par le fait qu'**il comprend en outre un élément d'engagement (140) adjacent à la seconde partie d'extrémité (27b) du deuxième rail (24), et l'élément d'engagement (140) comprend une partie de positionnement (142) et le troisième rail (26) **caractérisé par le fait qu'**il comprend en outre une ouverture (152) correspondant à la partie de positionnement (142) de l'élément d'engagement (140) de sorte que la partie de positionnement (142) de l'élément d'engagement (140) s'engage avec et se positionne à l'ouverture (152) du troisième rail (26) lorsque le troisième rail (26) se déplace par rapport au deuxième rail (24) dans une position étendue.

9. Ensemble de glissières (20) selon la revendication 8, **caractérisé par le fait que** l'élément d'engagement (140) comprend une plaque de base (144) et une partie élastique (146) se courbant depuis la plaque de base (144), la partie de positionnement (142) est située sur la partie élastique (146).

10. Ensemble de glissières (20) selon la revendication 6, **caractérisé par le fait qu'**il comprend en outre :
au moins un élément limiteur (118), fixé sur le deuxième rail (24) ; et
un élément de libération (120), monté sur le corps s'étendant de manière longitudinale (56) du deuxième rail (24) et adjacent à la partie en indentation (114) du deuxième rail (24), l'élément de libération (120) **caractérisé par le fait qu'**il comprend une partie mobile (122) et une partie de désengagement (124), soit la partie mobile (122) soit la partie de désengagement (124) comprend au moins une rainure longitudinale (126) correspondant au ou aux éléments limiteurs (118), la partie de désengagement (124) correspond à une partie de l'élément pivotant (86),
lorsque la partie mobile (122) est actionnée après engagement de la partie de jambe (92) de l'élément pivotant (86) avec la partie en indentation (114) du deuxième rail (24), la partie de désengagement (124) est entraînée pour déplacer la partie de l'élément pivotant (86) de sorte que la partie de jambe (92) de l'élément pivotant (86) est à nouveau désengagée de la partie en indentation (114) du deuxième rail (24).

11. Ensemble de glissières (20) selon la revendication 6, le troisième rail (26) **caractérisé par le fait qu'**il comprend en outre une inclinaison de guidage (150) adjacente à la partie en forme de crochet (148), lorsque le troisième rail (26) est rétracté le long d'une direction de rétractation, la partie de contact (110) de l'élément d'actionnement (100) est pressée en arrière pour s'engager avec la partie en forme de crochet (148) du troisième rail (26) par l'inclinaison de guidage (150) du troisième rail (26).

12. Ensemble de glissières (20) selon la revendication 11, **caractérisé par le fait que** la partie en indentation (114) du deuxième rail (24) comprend une inclinaison (116), lorsque le troisième rail (26) est rétracté le long d'une direction de rétractation, l'inclinaison (116) appuie contre la partie de jambe (92) de l'élément pivotant (86) de sorte que la partie de jambe (92) dévie et quitte la partie en indentation (114) du deuxième rail (24).

13. Ensemble de glissières (20) selon la revendication 6, **caractérisé par le fait qu'**il comprend en outre un élément d'actionnement (30) raccordé au troisième rail (26) pour être actionné pour déplacer le troisième rail (26) le long de la direction d'extension, le corps s'étendant de manière longitudinale (42) du premier rail (22) comprend une partie de fixation (43), l'élément d'actionnement (30) comprend une partie de plaque de base (31) raccordée au troisième rail (26), une plaque élastique (33) se courbant depuis la partie de plaque de base (31) pour fournir une force élastique, et une partie de préhension (37) raccordée à la plaque élastique (33), la plaque élastique (33) comprend une partie d'engagement (39) correspondant à la partie de fixation (43) du corps s'étendant de manière longitudinale (42) du premier rail (22), lorsque le troisième rail (26) est rétracté sur une position rétractée par rapport au premier rail (22), la partie d'engagement (39) de la plaque élastique (33) s'engage avec la partie de fixation (43) grâce à la force élastique fournie par la plaque élastique (33).
